# EUROPEAN PATENT APPLICATION

(11) **EP 1 921 053 A1**
(43) Date of publication of application: **14.05.2008**
(21) Application number: 07018393.4
(22) Date of filing: 19.09.2007
(51) Int. Cl.: C04B 35/64, C04B 35/505, H01J 37/00

(54) **Method for preparing yttria parts and plasma reactor parts comprising yttria**

(30) Priority: 30.10.2006 US 554482; 21.06.2007 US 766626
(71) Applicant: Applied Materials, Inc., Santa Clara, CA 95054 (US)
(72) Inventor: Ryabova, Elmira, Mountain View CA 94043 (US); Lewington, Richard, Hayward CA 94544 (US); Chandrachood, Madhavi R., Sunnyvale CA 94086 (US); Sabharwal, Amitabh, San Jose CA 95120 (US); Bivens, Darin, San Mateo CA 94401 (US); Sun, Jennifer, Sunnyvale CA 94086 (US); Yuan, Jie, San Jose CA 95131 (US)
(74) Representative: Zimmermann, Gerd Heinrich

(57) **Abstract**

A method of fabricating yttria parts is provided herein. In one embodiment, the method includes sintering a yttria sample, machining the sintered sample to form a part, and annealing the part by heating the part at a predetermined heating rate, maintaining the part at a constant annealing temperature, and cooling the part at a predetermined cooling rate.

## Description

Embodiments of the present invention generally relate to a method and apparatus for plasma processing and, more specifically, to a method and apparatus for plasma processing with improved component parts. Specifically, they related to methods of fabricating a yttria part and a part for use in a plasma reactor.

The fabrication of microelectronics or integrated circuit devices typically involves a complicated process sequence requiring hundreds of individual steps performed on semiconductive, dielectric and conductive substrates. Examples of these process steps include oxidation, diffusion, ion implantation, thin film deposition, cleaning, etching and lithography.

Using lithography and etching (often referred to as pattern transfer steps), a desired pattern is first transferred to a photosensitive material layer, e.g., a photoresist, and then to the underlying material layer during subsequent etching. In the lithographic step, a blanket photoresist layer is exposed to a radiation source through a reticle or photomask containing a pattern so that an image of the pattern is formed in the photoresist. By developing the photoresist in a suitable chemical solution, portions of the photoresist are removed, thus resulting in a patterned photoresist layer. With this photoresist pattern acting as a mask, the underlying material layer is exposed to a reactive environment, e.g., using wet or dry etching, which results in the pattern being transferred to the underlying material layer. The terms "mask", "photomask" or "reticle" will be used interchangeably to denote generally a substrate containing a pattern.

The pattern on a photomask, which is typically formed in a metal-containing layer supported on a glass or quartz substrate, is also generated by etching through a photoresist pattern. In this case, however, the photoresist pattern is created by a direct write technique, e.g., with an electron beam or other suitable radiation beam, as opposed to exposing the photoresist through a reticle. With the patterned photoresist as a mask, the pattern can be transferred to the underlying metal-containing layer using plasma etching.

Plasma processes are often used for thin film deposition and etching, which are performed in a plasma chamber. In chemical vapor deposition, reactive species are generated by applying voltages to suitable process gases, and subsequent chemical reactions result in the formation of a thin film on a substrate. In plasma etching, a previously deposited film is exposed to the reactive species in a plasma, often through a patterned mask layer formed in a prior lithography step. Reactions between the reactive species and the deposited film result in the removal, or etching, of the deposited film.

When chamber parts or process kits are exposed to the plasma environment for extended periods, deterioration may occur due to reaction with the plasma species. For example, existing process kits or component parts of a plasma chamber are often made of alumina (aluminum oxide). Halogen-containing gases, e.g., fluorine- or chlorine-containing gases, are used in etching various material layers in circuit fabrication. It is believed that alumina is vulnerable to attack by fluorine species, resulting in the formation of AlₓF_{y}O_{z} on the surface of component parts. Such etch by-product may come off as particles during processing, resulting in contamination and defects on the mask substrate. Furthermore, some alumina parts seem to be susceptible to breakage, probably as a result of mechanical stress created during machining. Thus, there is a need for alternative ceramic materials suitable for use as component parts for plasma applications, and for improved processes for fabricating such materials.
In light of the above, a method of fabricating a yttria part according to independent claim 1, a part for use in a plasma reactor according to independent claim 19, and a plasma process chamber according to claim 21 are provided.
Further advantages, features, aspects and details of the invention are evident from the dependent claims, the description and the drawings.

The invention provides a method of fabricating a yttria part, comprising: (a) providing a yttria sample, (b) sintering the yttria sample, (c) machining the sintered yttria sample to form a part, and (d) annealing the part.

Another embodiment of the invention provides a part comprising at least about 99.5 percent yttria for use in a plasma reactor.

Yet another embodiment of the invention provides a plasma process chamber, comprising: a chamber body, a part made of at least about 99.5 percent yttria disposed in the chamber body, a support pedestal disposed in the chamber body and adapted to receive a substrate thereon; and a power source for forming a plasma within the chamber.
Embodiments are also directed to apparatuses fabricated by the disclosed methods and including apparatus parts fabricated by the method steps. Furthermore, embodiments are also directed to methods by which the described apparatus is manufactured. It may include method steps for manufacturing parts of the apparatus. The method steps may be performed by way of hardware components, firmware, a computer programmed by appropriate software, by any combination thereof or in any other manner.

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a schematic illustration of a method for fabricating bulk yttria parts according to the present invention;

Figure 2 is a schematic diagram of a plasma etch reactor having at least one bulk yttria part made according to a method of the invention;

Figure 3A-B are a schematic illustrations of the top and cross-sectional views of a cover ring;

Figure 4A-B are schematic illustrations of the top and cross-sectional views of a capture ring;

Figure 5 is a schematic illustration of a cross-sectional view of one embodiment of a gas inlet (nozzle);

Figure 6 is a schematic diagram of a plasma etch reactor having at least one bulk yttria part made according to a method of Figure 1;

Figure 7 is a schematic illustration of a top view of a gas distribution plate;

Figure 8 is a schematic illustration of a cross-sectional view of several component parts inside a chamber; and

Figures 9A-B are schematic illustrations of the top and cross-sectional views of a yttria ring.

To facilitate understanding, identical reference numerals have been used, where possible, to designate identical elements that are common to the figures. It is contemplated that elements and features of one embodiment may be beneficially incorporated in other embodiments without further recitation.

It is to be noted, however, that the appended drawings illustrate only exemplary embodiments of this invention and are therefore not to be considered limiting of its scope, for the invention may admit to other equally effective embodiments.

Certain embodiments of the present invention provide a method for fabricating parts made of bulk or solid yttria with improved characteristics such as reduced stress and enhanced chemical resistance. Certain other embodiments include chamber components made of bulk or solid yttria with improved characteristics, and processing chambers utilizing the same. Specifically, it is found that such improved characteristics are obtained if a part is subjected to a high temperature anneal after it is machined. Additionally, such characteristics may be further improved if the part is sintered or annealed in an oxygen containing environment.

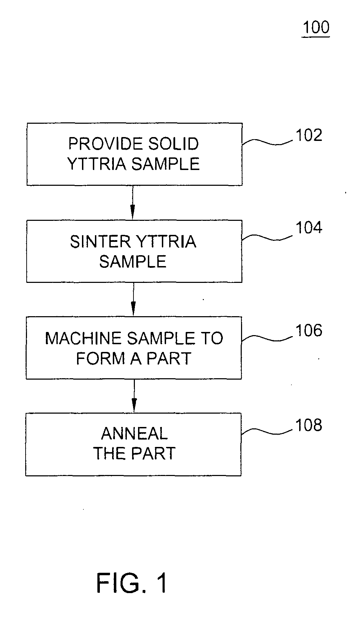

Figure 1 illustrates one embodiment of a method 100 that can be used to fabricate these improved yttria parts. A solid yttria sample is provided at the beginning of the process in block 102 of the method 100. The solid yttria sample may be made by a variety of techniques known to one skilled in the art. For example, yttria (yttrium oxide, Y₂O₃) in powder form may be used as the starting material, and a slurry is formed by adding other components such as water, binder, and suitable additives that may be used to facilitate the fabrication process or to enhance the properties of the parts. After drying, the slurry is press-molded into a block to form the solid yttria sample.

At block 104, the solid yttria sample is sintered by exposing it to a high temperature environment, which causes the yttria particles to fuse together. Depending on specific application needs, sintering may be performed by exposing the yttria solid sample to various gaseous atmospheres or environments. In one embodiment, sintering is performed under an oxygen-containing atmosphere, for example, a mixture containing oxygen (O₂) and nitrogen (N₂), with an O₂ partial pressure ranging from about 0.001 atmosphere (atm.) to about 1 atm. The annealing may be done at a total pressure during of about 1 atm., although other pressures may also be used. In another embodiment, the sintering mixture has an O₂ concentration of at least about 2 percent by volume. In another embodiment, sintering is performed under an inert or non-oxidative atmosphere, e.g., nitrogen (N₂), or other inert gases.

After sintering, the yttria sample is machined into a part, as shown in block 106. In general, the part may be any component part of different equipment or machines, and may be have a variety of shapes or dimensions. In one embodiment, the machined part is a component of a plasma processing chamber, with a purity level higher than about 99.9 percent. In other embodiments, samples with a purity level higher than about 99.5 percent yttria are also suitable for use in plasma processing chambers.

At block 108, the machined part is subjected to an annealing process at an elevated temperature under controlled conditions. The choice of one or more of the annealing conditions, e.g., annealing gas, heating or cooling rates, may depend on the specific sintering atmosphere used in preparing the ytrria sample. According to one embodiment of the invention, at least one of the sintering or annealing is performed under an oxygen-containing atmosphere. The selection of the heating and cooling rates during annealing also depend on the sintering atmosphere used. After annealing, the part may undergo further processing, as needed, to prepare it for use or installation.

According to one embodiment of the present invention, the annealing process at block 108 comprises three stages. During the first stage, the part is exposed to an annealing gas and subjected to a ramp-up heating from a first temperature, e.g., ambient temperature, to a second, predetermined, temperature. In the second stage, the part is maintained at the second temperature (the annealing temperature) for a time period that is sufficient to substantially relieve any stress that might have been created or induced by the previous machining operation, and to provide the desired chemical resistance. In the third stage, the part is subjected to a ramp-down cooling back to the first temperature.

As previously mentioned, the sintering atmosphere may affect the choice of one or more of the annealing conditions. For example, if the sintering process at block 104 is done in an inert or non-oxidative atmosphere such as N₂, or other inert gases, the yttria part will be exposed to an oxygen-containing gas during at least part of the annealing process. In one embodiment, the annealing gas is a mixture with an O₂ concentration of about 10 percent by volume, with the balance being N₂ or other inert gases.

On the other hand, if the sintering is done in an oxygen-containing atmosphere, then there is no need to expose the part to an oxygen-containing atmosphere during annealing.

In addition, for yttria samples that have been sintered under an inert or non-oxidative atmosphere, a more careful control of the annealing conditions may be needed, since outgassing from the samples may change the gas environment around the samples. Thus, circulation of the annealing gas may be provided to ensure a more uniform exposure of the yttria part to the annealing atmosphere, with periodical monitoring of various parameters such as temperatures, pressures and gas compositions.

In one embodiment, the annealing process at block 108 is performed in an oven with air at atmospheric pressure. Using air as the annealing gas offers the advantages of both convenience and relatively low cost. For some yttria parts of interest, e.g., those with a purity level of at least about 99.5 percent yttria, annealing in air is sufficient to provide the desired properties in the finished parts, and there is no particular need for gas mixtures with more active components such as a reducing or oxidizing atmosphere. Other inert or non-reactive atmospheres may also be used for annealing the yttria parts, e.g., nitrogen, argon, among others, or mixtures thereof; or other relatively inert mixtures with oxygen concentrations different from that of air. Depending on the specific applications, certain parts may benefit from the use of forming gas (e.g., a mixture of 4 percent or less than 10 percent by volume of hydrogen in nitrogen), or gas mixtures containing different concentrations of hydrogen, or reducing or oxidizing gases. For example, if surface modification is needed, e.g., chemical modification or passivation, then annealing may be done in a reducing or oxidizing environment, as appropriate.

In another embodiment in which sintering of the solid yttria sample is performed under a non-oxidative or inert atmosphere, the annealing gas comprises an oxygen-containing atmosphere, e.g., an oxygen concentration of at least about 10 percent by volume.

The annealing can be done under a static or gas flow environment. The static condition offers the advantage of reduced cost, while the gas flow configuration is beneficial for annealing involving chemical reactions with the sample so that a fresh supply of the annealing gas can be maintained. For parts with certain geometric shapes or features such as grooves, it may also be advantageous to use turbulent flow as opposed to laminar flow conditions.

The ramp-up heating and ramp-down cooling rates during the annealing process are controlled to be sufficiently slow in order to minimize stress that might arise from non-uniform thermal expansion or contraction, while high enough to provide a practical throughput for the process. Thus, each of the ramp-up heating and ramp-down cooling stages may take place over a time period from about 8 hours to about 48 hours, with the specific time being dependent on the specific parts.

In addition to the size, shape, surface area to volume ratio, and thermal properties of the parts such as coefficient of thermal expansion or thermal capacity, the sintering atmosphere used in forming the yttria sample also affects the choice of the heating or cooling rates during annealing. Thus, according to one embodiment, the heating and cooling rates are selected based at least on the sintering atmosphere used during sintering. It is believed that the sintering ambient results in certain changes to the surface properties of the yttria sample, and thus, a corresponding adjustment to the annealing conditions may be needed to ensure proper bulk properties transition. In general, samples with higher local concentrations of stress or strain would require slower heating and cooling rates. Thus, parameters such as shape and thickness of the sample tend to be more important in determining the ramp-up heating or ramp-down cooling rates.

In one embodiment, a steady or constant heating rate is used, and is controlled such that an external temperature gradient does not exceed about 1 Kelvin per centimeter (K/cm) near the surface of the part. In this context, the external temperature gradient refers to the temperature gradient close to the surface of the part, e.g., in a region close to the interface between the part and the annealing gas. In another embodiment, the heating rate is controlled such that an internal temperature or thermal gradient within the part does not exceed about 10 Joules per kilogram per Kelvin (J/kg-K). In yet another embodiment, the heating rate is controlled to maintain both the external and internal thermal gradients to be below the respective limits throughout the first time period.

For yttria samples that have been sintered in an oxygen-containing atmosphere, a lower heating rate may be needed during the ramp-up heating stage in order to avoid undesirable thermal stress, e.g., about a factor of three to five slower than other samples with comparable geometric shapes and thicknesses but sintered in an inert or non-oxidative atmosphere. Thus, the heating rates may be controlled such that the external temperature gradient is between about 0.2 to about 0.3 K/cm, and the internal temperature gradient is between about 2 to about 3 J/kg-K. In one embodiment, the heating rate is controlled such that the external temperature gradient does not exceed about 0.3 K/cm. Alternatively, the heating rate is controlled such that the internal temperature gradient does not exceed about 3 J/kg-K.

The annealing temperature used in the second stage depends on the specific yttria part, and may also depend on the additives used in the parts. In general, the annealing temperature should be at least about 200 Kelvin lower than the eutectic point for the material composition. For the yttria parts of interest, a range of about 200 degrees Celsius to about 1000 degrees Celsius can be used, while in one embodiment, the annealing temperature is between about 800 degrees Celsius to about 1000 degrees Celsius. The time period for the second stage depends on the specific part, e.g., dimension, shape or compositions. Parts that are relatively large, or those with shapes that may be prone to mechanical stress, will generally require a longer annealing period. For some embodiments, the annealing period may span over several days, e.g., from 4 to about 7 days.

In the ramp-down cooling stage, the part is cooled at a controlled rate according to similar criteria in order to minimize thermal stress that might otherwise arise at excessively high cooling rates. In one embodiment, the part is cooled at a steady or constant rate that is approximately the same as that used during ramp-up heating.

After annealing, the part may undergo further processing, as needed, to prepare it for use or installation.

It is found that the bulk yttria part fabricated using this method exhibits improved properties including, for example, reduced stress and enhanced chemical resistance. A comparative study has been performed to demonstrate the improved properties of a bulk yttria sample after it has been processed through annealing according to one embodiment of the invention. In particular, surface roughness, brightness and X-ray diffraction results from three batches of yttria coupons or samples are compared. The three samples were processed through different fabrication steps: 1) as-sintered; 2) machined; and 3) machined and annealed. The samples were then exposed to fluorine- and oxygen-containing plasmas for about 12 hours. Surface roughness measurements show that Sample #3 has a surface roughness that is lower than that of the as-sintered sample (Sample #1), but about the same as that of Sample #2.

X-ray diffraction results show that the as-sintered sample #1 contains two different phases with microcrystallite structures. After machining, the surface of the sample became single-phase, which is more desirable than a dual-phase sample. The machined and annealed sample remains single-phase, but the stress level is reduced compared to sample #2.

Finally, the erosion resistance after plasma exposure was also compared, and sample #3 was found to have minimal erosion, followed by the as-sintered sample #1, while the machined-only sample #2 exhibits the most erosion.

These results suggest that the machined and annealed part (sample #3) is best suited for use in a plasma environment because of the reduced stress. The smoother finish also reduces particle generation arising from materials deposited during processing.

Although the method can generally be used to fabricate a variety of yttria parts of different dimensions or shapes, it is particularly beneficial for certain machined parts that are more prone to mechanical stress, e.g., parts with openings or angular portions or shapes.

Embodiments of this invention can be used to fabricate yttria parts for a variety of applications. These improved parts are also suitable for use in corrosive environments such as those encountered in plasma processes. A variety of plasma deposition and etch chambers may benefit from the teachings disclosed herein, for example, the Decoupled Plasma Source (DPS^{®}) II reactor, the Tetra I and Tetra II Photomask etch systems, dielectric etch chambers such as the ENABLER^{®} etch chamber, which may be part of a semiconductor wafer processing system such as the CENTURA^{®} system, the eMax etch chamber, the Producer etch chamber, as well as conductor etch chambers such as AdvantEdge Metal and the DPS Metal chambers, among others, all of which are available from Applied Materials, Inc. of Santa Clara, California. Details of the ENABLER^{®} chamber have been disclosed in U.S. patent 6,853,141, "Capacitively Coupled Plasma Reactor with Magnetic Plasma Control".
Details of another embodiment of an etch reactor have been disclosed in U.S. patent application S/N 10/882,084 (Attorney Docket No. 9400), entitled "Method and Apparatus for Photomask Plasma Etching". It is contemplated that other plasma reactors, including those from other manufacturers, may be adapted to benefit from the invention.

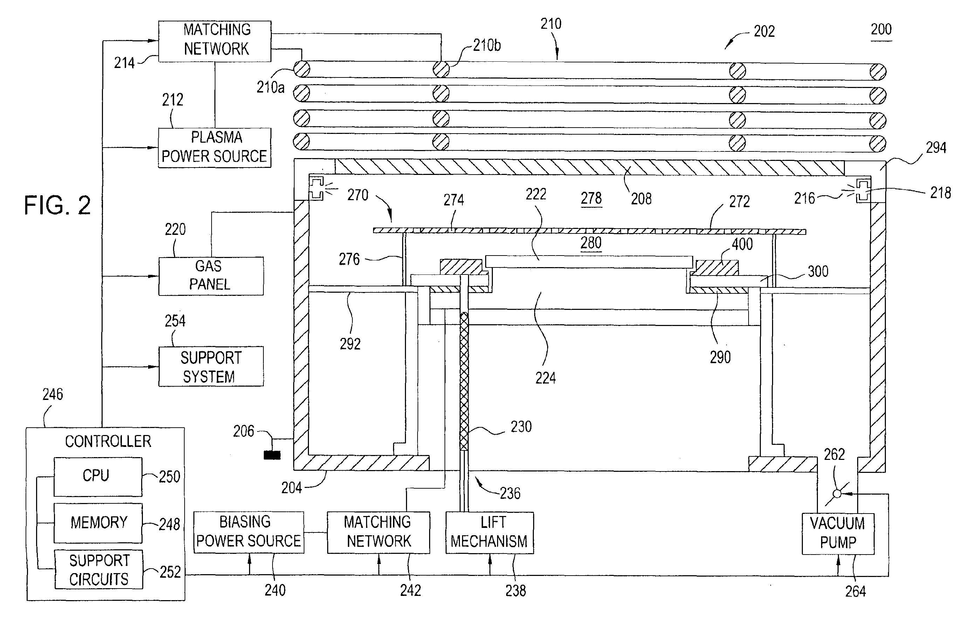

Figure 2 depicts a schematic diagram of an etch reactor 200 with certain component parts made of bulk yttria. The embodiment of the reactor 200 shown herein is provided for illustrative purposes and should not be used to limit the scope of the invention.

The reactor 200 generally comprises a process chamber 202 having a substrate pedestal 224 within a conductive body (wall) 204, and a controller 246. The chamber 202 has a substantially flat ceiling or chamber lid 208. Other modifications of the chamber 202 may have other types of ceilings, e.g., a dome-shaped ceiling. An antenna 210, disposed above the lid 208, comprises one or more inductive coil elements that may be selectively controlled (two coaxial elements 210a and 210b are shown in Figure 2) through a first matching network 214 coupled to a plasma power source 212. The plasma power source 212 is typically capable of producing up to about 3000 W at a tunable frequency in a range from about 50 kHz to about 13.56 MHz.

The substrate pedestal (cathode) 224 is coupled through a second matching network 242 to a biasing power source 240. The biasing source 240 generally is a source of up to about 500 W at a frequency of approximately 13.56 MHz that is capable of producing either continuous or pulsed power. Alternatively, the source 240 may be a DC or pulsed DC source.

In one embodiment, the substrate support pedestal 224 has a central protruding portion having a shape and dimensions that substantially match those of a typical substrate, e.g., a square shaped substrate. A cover ring 300 and a capture ring 400, both made of bulk yttria by the process 100 described above, are disposed above the substrate support pedestal 224. An annular insulator 290 is provided between an outer portion of the substrate support pedestal 224 and the cover ring 300.

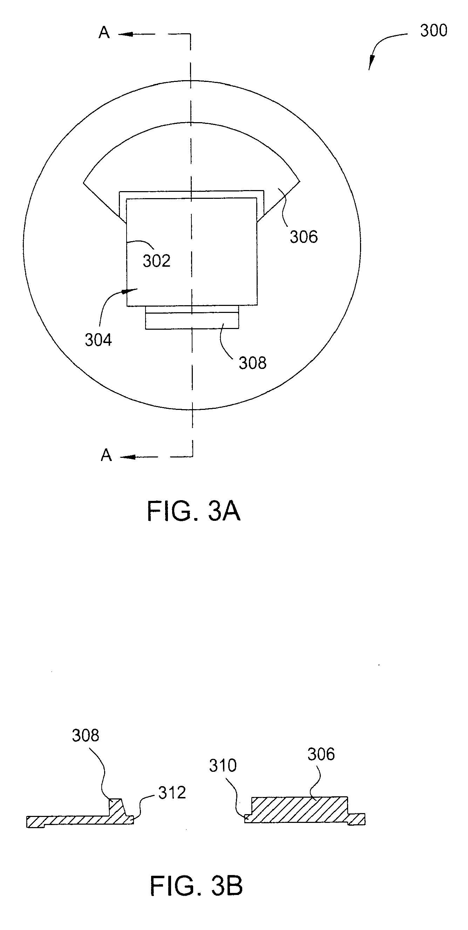

Figures 3A-B are schematic illustrations of the top and cross-sectional views of the cover ring 300. The cover ring 300 has an inner perimeter 302 defining a center opening 304 that is shaped and sized to substantially match the substrate 222, and two top protruding portions 306 and 308 disposed adjacent to the opening 304. As shown in Fig. 3A, the protruding portion 306 is in the shape of a segment of an annular ring with a truncated inner portion that substantially matches a portion of the inner perimeter 302. The other protruding portion 308 is substantially rectangular in shape. Lip portions 310 and 312 are provided adjacent to the protruding portions 306 and 308, respectively.

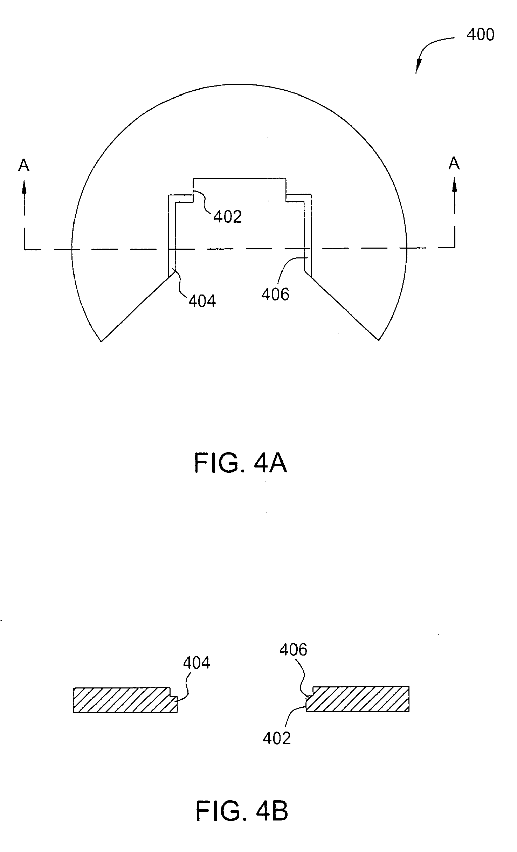

The capture ring 400, shown schematically in the top and cross-sectional views of Figures 4A-B, has a C-shape, e.g., resembling an annular ring with a segment removed. It is provided with lip portions 404 and 406, which are used for receiving and supporting a substrate (e.g., photomask or reticle) during transfer to and from the pedestal 224. The capture ring 400 has an inner perimeter 402 that is sized and shaped to substantially match the inner perimeter 302 and the protruding portions 306, 308 of the cover ring 300. The capture ring 400 is designed to be moved between two positions by a lift mechanism 238 (shown in Fig. 2), comprises a plurality of lift pins 230 (one lift pin is shown) that travel through respective guide holes 236. In a first position, the capture ring 400 is lowered beneath the top surface of the pedestal 224, leaving the substrate 222 supported by the pedestal 224 for processing. In this first position, the capture ring 400 essentially couples with the protruding portions 306, 308 of the cover ring 300 to form a complete annular ring such that the top surfaces of the capture ring 400 and the cover ring 300 are substantially in the same horizontal plane. That is, at least certain portions of the capture ring 400 and the cover ring 300 are complementarily shaped. After substrate processing is completed, the capture ring 400 is lifted upwards to its second position, supporting the substrate 222 for transfer out of the chamber 202, and is ready for receiving another substrate for processing.

During processing, the temperature of the substrate 222 is controlled by stabilizing the temperature of the substrate pedestal 224 by flowing a coolant through one or more channels (not shown) provided in the pedestal 224.

In one embodiment, an ion-radical shield 270 is disposed in the chamber 202 above the pedestal 224. The ion-radical shield 270 is electrically isolated from the chamber walls 204 and the pedestal 224, and generally comprises a substantially flat plate 272 supported by a plurality of legs 276 above the pedestal 224. The plate 272 defines one or more openings or apertures 274 that collectively provide a desired open area in the surface of the plate 272 for controlling the amount of ions that pass from a plasma formed in an upper process volume 278 of the process chamber 202 to a lower process volume 280 located between the ion-radical shield 270 and the substrate 222. The plurality of legs 276 are generally located around an outer perimeter of the cover ring 300 and may be fabricated of the same material as the plate 272. The legs 276 may be coupled or secured to the plate 272 and a screen 292 provided underneath the outer perimeter of the cover ring 300 using various methods. At least one of the legs 276, ring 300 or plate 272 may be fabricated using the method 100 described above.

One or more process gases are provided to the process chamber 202 from a gas panel 220 through one or more inlets 216 (e.g., openings, injectors, nozzles, and the like) located above the substrate pedestal 224. In the embodiment depicted in Figure 2, the process gases are provided to the inlets 216 through an annular gas channel 218 formed in an annular gas injection ring 294 disposed around the chamber lid 208. In one embodiment, the chamber lid 208 is a blank circular lid having a diameter of about 20 inches, and the gas inlet 216 has maximum longitudinal and lateral dimensions each being less than 1 inch, and both are made of solid yttria according to the fabrication method 100 of the present invention. Alternatively, the annular gas injection ring 294 may be provided with the chamber lid 208 as a single component, e.g., an integrated gas injection lid.

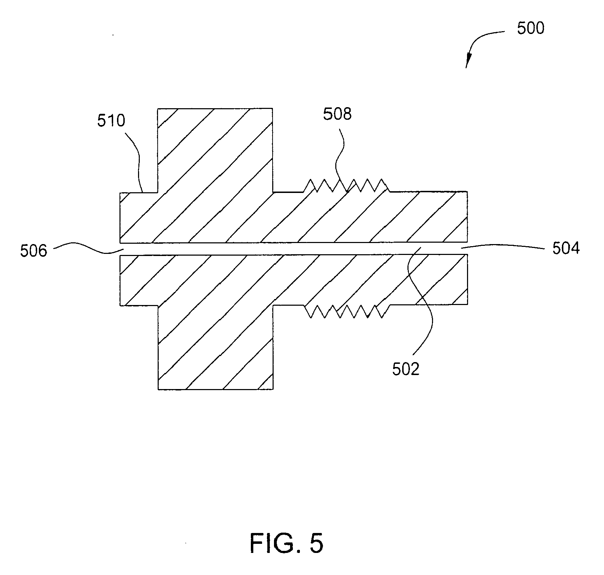

Figure 5 is a schematic cross-sectional view of one embodiment of a gas inlet, shown as a nozzle 500. The nozzle 500 includes a conduit 502 oriented along a longitudinal direction of the nozzle 500. The conduit 502 has a first end 504 coupled to the gas channel 218 and a second end 506 through which process gases exit into the chamber 202. The nozzle 500 may be fabricated using the method 100 described above. The nozzle 500 further has a first cylindrical portion 508 for coupling to the gas injection ring 294, among others. In one embodiment, the cylindrical portion 508 is threaded, and a flat portion 510 is provided near the second end 506 to facilitate the coupling of the cylindrical portion 508 to a corresponding aperture in the gas injection ring 294. Although only certain component parts in this illustrative embodiment of the etch reactor 200 are made of bulk yttria, other component parts such as the legs 276 and gas injection ring 294, among others, which are currently made of either anodized aluminum or aluminum with spray-coated yttria, may also be fabricated as bulk yttria parts according to the method 100. In addition, component parts used in other plasma processing chambers (e.g., gas distribution plate, shower head, chamber liner, shadow ring and so on) may also be fabricated according to the method 100.

During an etch process, power from the plasma source 212 is applied to the antenna 210 to generate a plasma from the process gases. The pressure in the chamber 202 is controlled using a throttle valve 262 and a vacuum pump 264. The temperature of the wall 204 may be controlled using liquid-containing conduits (not shown) that run through the wall 204. Typically, the chamber wall 204 is formed from a metal (e.g., aluminum, stainless steel, among others) and is coupled to an electrical ground 206. The process chamber 202 also comprises conventional systems for process control, internal diagnostic, end point detection, and so on. Such systems are collectively shown as support systems 254.

The controller 246 comprises a central processing unit (CPU) 250, a memory 248, and support circuits 252 for the CPU 250 and facilitates control of the components of the process chamber 202 and, as such, of the etch process, as discussed below in further detail. The controller 246 may be one of any form of general-purpose computer processor that can be used in an industrial setting for controlling various chambers and sub-processors. The memory, or computer-readable medium of the CPU 250 may be one or more of readily available memory such as random access memory (RAM), read only memory (ROM), floppy disk, hard disk, or any other form of digital storage, local or remote. The support circuits 252 are coupled to the CPU 250 for supporting the processor in a conventional manner. These circuits include cache, power supplies, clock circuits, input/output circuitry and subsystems, and the like. The inventive method is generally stored in the memory 248 as a software routine. Alternatively, such software routine may also be stored and/or executed by a second CPU (not shown) that is remotely located from the hardware being controlled by the CPU 250.

In one embodiment, one or more process gases comprising at least one halogen-containing gas, e.g., fluorine-containing or chlorine-containing gas, is introduced into the chamber 202 via gas inlets 216. In general, a fluorine-containing gas, e.g., CHF₃, CF₄, among others, is used for etching quartz and MoSi layers on the substrate 222, while a chlorine-containing gas such as chlorine (Cl₂), is used for etching chromium. A plasma is formed from the process gases by applying RF power to the antenna 210, e.g., at a power level of about 350 W and a frequency of about 13.56 MHz. The ion-neutral shield 270 controls the amount of ions passing through the apertures 274, while allowing predominantly neutral species in the plasma into the lower process volume 280 for etching the substrate 222.

Such an etch process can benefit from the use of yttria parts fabricated according to the method of the present invention because of the improved properties of the parts resulting in reduced maintenance and particle contamination.

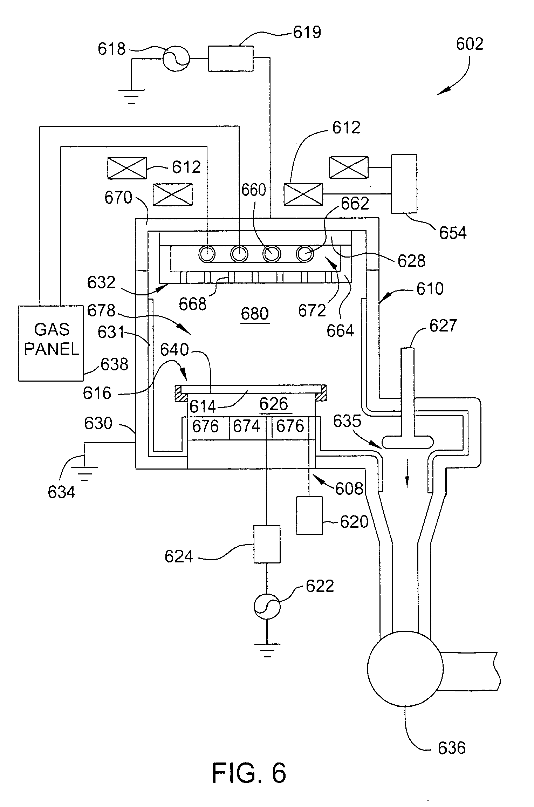

Figure 6 depicts a schematic, cross-sectional diagram of an illustrative plasma processing chamber 602 that can benefit from embodiments of this invention, e.g., one or more parts can be fabricated using the method 100 described herein. The embodiment of the reactor shown herein is provided for illustrative purposes and should not be used to limit the scope of the invention, as it is contemplated that parts fabricated using the method 100 described herein may be beneficially utilized in other processing chambers, including those from other manufacturers.

In this embodiment, chamber 602 is used for plasma processing, e.g., etching, of a substrate 614. Process uniformity can be tuned by using a gas diffuser 632, which is designed to enable compensation for conductance or other chamber attributes that cause asymmetrical processing, i.e., processing results that are not symmetrically relative to a centerline of the substrate.

In one embodiment, chamber 602 comprises a vacuum chamber body 610 having a conductive chamber wall 630 and bottom 608. The chamber wall 630 is connected to an electrical ground 634. A lid 670 is disposed on the chamber wall 630 to enclose an interior volume 678 defined within the chamber body 610. At least one solenoid segment 612 is positioned exterior to the chamber wall 630. The solenoid segment(s) 612 may be selectively energized by a DC power source 654 that is capable of producing at least 5V to provide a control knob for plasma processes formed within the processing chamber 602.

A ceramic liner 631 is disposed within the interior volume 678 to facilitate cleaning of the chamber 602. The byproducts and residue of the etch process may be readily removed from the liner 631 at selected intervals.

A substrate support pedestal 616 is disposed on the bottom 608 of the process chamber 602 below the gas diffuser 632. A process region 680 is defined within the interior volume 678 between the substrate support pedestal 616 and the diffuser 632. The substrate support pedestal 616 may include an electrostatic chuck 626 for retaining a substrate 614 on a surface 640 of the pedestal 616 beneath the gas diffuser 632 during processing. The electrostatic chuck 626 is controlled by a DC power supply 620.

The support pedestal 616 may be coupled to an RF bias source 622 through a matching network 624. The bias source 622 is generally capable of producing an RF signal having a tunable frequency of 50 kHz to 13.56 MHz and a power of between 0 and 5000 Watts. Optionally, the bias source 622 may be a DC or pulsed DC source.

The support pedestal 616 may also include inner and outer temperature regulating zones 674, 676. Each zone 674, 676 may include at least one temperature regulating device, such as a resistive heater or a conduit for circulating coolant, so that the radial temperature gradient of the substrate disposed on the pedestal may be controlled.

The interior of the chamber 602 is a high vacuum vessel that is coupled to a vacuum pump 636 through an exhaust port 635 formed through the chamber wall 630 and/or chamber bottom 608. A throttle valve 627 disposed in the exhaust port 635 is used in conjunction with the vacuum pump 636 to control the pressure inside the processing chamber 602. The position of the exhaust port 635 and other flow restrictions within the interior volume 678 of the chamber body 610 greatly influence the conductance and gas flow distribution within the processing chamber 602.

The gas diffuser 632 provides a conduit through which at least one process gas is introduced into the processing region 680 in an asymmetrical manner that may be used to tune the conductance and gas flow distribution described above that are caused by the other chamber components (i.e., location of the exhaust port, geometry of the substrate support pedestal or other chamber component) so that the flow of gases and species are delivered to the substrate in a uniform, or selected, distribution. Moreover, the gas diffuser 632 may be utilized to position the plasma relative to the centerline of the substrate 614 (which is concentrically disposed on the pedestal 616). As a result, the configuration of the gas diffuser 632 may be selected to improve process uniformity, or alternatively, create a predefined offset in processing results. For example, the configuration of the gas diffuser 632 may be selected to direct the flow of gas entering the process region 680 above the substrate support pedestal 616 in a manner that compensates for the chamber conductance. This may be accomplished by configuring the gas diffuser 632 to deliver gas into the process chamber with an asymmetry that offsets the asymmetric effects of the chamber conductance on plasma location and/or the delivery of ions and/or reactive species to the surface of the substrate during processing.

In the embodiment depicted in Figure 6, the gas diffuser 632 includes at least two gas distributors 660, 662, a mounting plate 628 and a gas distribution plate 664.

The gas distributors 660, 662 are coupled to one or more gas panels 638 through the lid 670 of the processing chamber 602, and are also coupled to at least one of the mounting or gas distribution plates 628, 664. The flow of gas through the gas distributors 660, 662 may be independently controlled. Although the gas distributors 660, 662 are shown coupled to a single gas panel 638, it is contemplated that the gas distributors 660, 662 may be coupled to one or more shared and/or separate gas sources. Gases provided from the gas panel 638 are delivered into a region 672 defined between the plates 628, 664, then exit through a plurality of apertures 668 formed through the gas distribution plate 664 into the processing region 680.

The mounting plate 628 is coupled to the lid 670 opposite the support pedestal 616. The mounting plate 628, which is fabricated from or covered by an RF conductive material, is coupled to an RF source 618 through an impedance transformer 619 (e.g., a quarter wavelength matching stub). The source 618 is generally capable of producing an RF signal having a tunable frequency of about 262 MHz and a power between about 0 and 2000 Watts. The mounting plate 628 and/or gas distribution plate 664 is powered by the RF source 618 to maintain a plasma formed from the process gases in the process region 680.

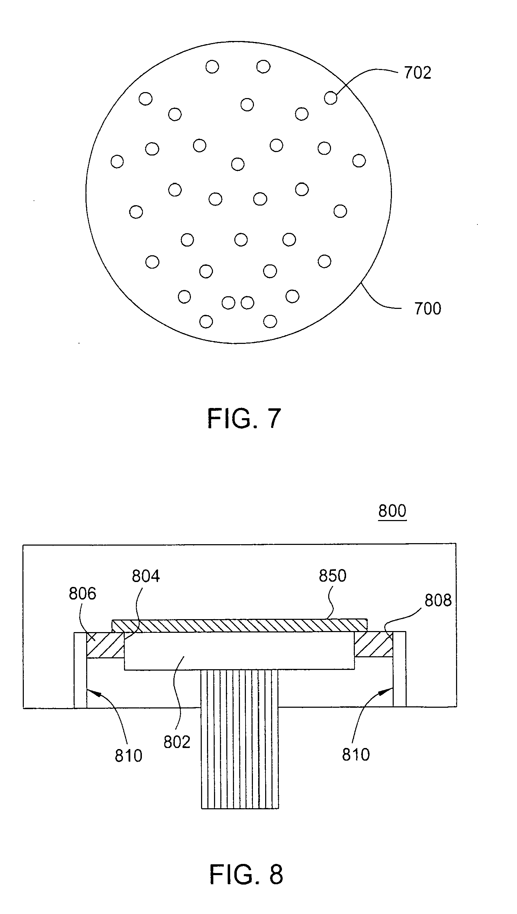

Figure 7 is a schematic illustration of a top view of a gas distribution plate 700 that can be fabricated according to embodiments of this invention. The yttria gas distribution plate 700 can be used in chamber 602 or other plasma chambers, such as those for etching or deposition applications, among others. The gas distribution plate 700 is provided with a plurality of apertures or gas inlets 702 to allow passage of process gases and/or plasma species into a process region of the chamber. The apertures 702 may be arranged in a regular pattern on the gas distribution plate 700, or they may be arranged in different patterns to allow for different gas distribution needs. The gas distribution plate 700 may have a thickness ranging from about 0.125 inches to about 0.750 inches, and the apertures 702 may have diameters ranging from about 0.01 inch to about 0.03 inch.

In one embodiment, one or more process gases comprising at least one halogen-containing gas, e.g., fluorine-containing or chlorine-containing gas, is introduced into the chamber 602 via gas inlets 702. In general, a fluorine-containing gas, e.g., CHF₃, CF₄, among others, may be used for etching dielectric materials on the substrate 614, while a chlorine-containing gas such as chlorine (Cl₂), is used for etching materials such as metal. These types of etch processes can benefit from the use of yttria parts fabricated according to embodiments of the present invention because of improved corrosion resistance of the parts resulting in reduced maintenance and particle contamination.

Figure 8 is a schematic illustration of a cross-sectional view of several component parts inside a process chamber 800, which may be a plasma chamber or a chamber designed for processing a substrate in a corrosive environment. The chamber 800 comprises a pedestal 802 for supporting a substrate 850. In one embodiment, the outer perimeter 804 of the pedestal 802 is surrounded by a ring 806, which is used to isolate the substrate, e.g., wafer, from other chamber components. The ring 806 can be attached or mounted to the pedestal 802 using a variety of suitable techniques.

For certain chambers such as those used for metal or conductor etching, the ring 806 may be made of yttria according to embodiments of the present invention. For other chambers such as those used for dielectric etching, a yttria liner 810 fabricated according to embodiments of the present invention may be provided around the outer perimeter 808 of the ring 806. The liner 810 protects the chamber walls by shielding them from the process gases or undesirable deposits. In the case of dielectric etching chamber, the ring 806 is typically made of other materials.

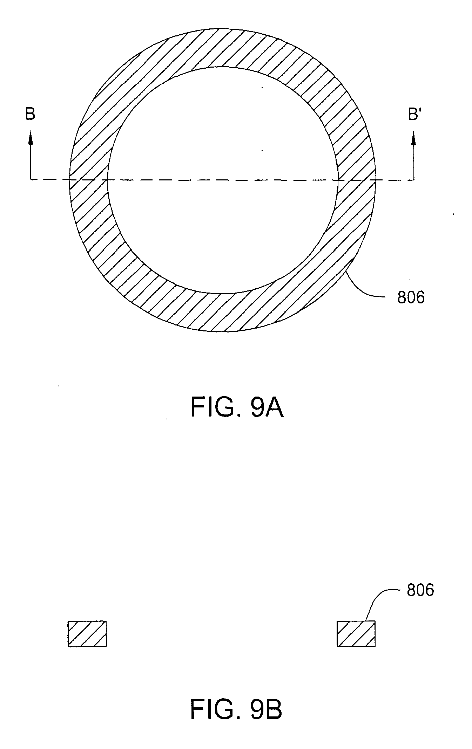

Figure 9A is a schematic illustration of a top view of one embodiment of the ring 806 having an annular shape, and Figure 9B shows a cross-sectional view taken along the line BB'. In one embodiment, the ring 806 has a thickness of about 0.3 cm, and an inner diameter of about 30 cm. and an outer diameter of about 35 cm. Since the geometric shape and the thickness of this ring do not contribute to excessive mechanical stress or strain, the ramp-up heating and ramp-down cooling during the annealing stage can be performed under less stringent requirements, e.g., at a heating or cooling rate such that an external temperature gradient does not exceed about 1 Kelvin per centimeter (K/cm) near the surface of the part, or an internal temperature or thermal gradient within the part does not exceed about 10 Joules per kilogram per Kelvin (J/kg-K).
According to some embodiments a method of fabricating yttria parts is provided. The method may include sintering a yttria sample, machining the sintered sample to form a part, and annealing the part by heating the part at a predetermined heating rate, maintaining the part at a constant annealing temperature, and cooling the part at a predetermined cooling rate.

While the foregoing is directed to embodiments of the present invention, other and further embodiments of the invention may be devised without departing from the basic scope thereof, and the scope thereof is determined by the claims that follow.

## Claims

1. A method of fabricating a yttria part, comprising:
(a) providing a yttria sample;
(b) sintering the yttria sample;
(c) machining the sintered yttria sample to form a part; and
(d) annealing the part.

2. The method of claim 1, wherein (d) further comprises:
(d1) exposing the part to an annealing gas in an enclosure;
(d2) heating the part from a first temperature to a second temperature over a first time period;
(d3) maintaining the part at the second temperature for a second time period; and
(d4) cooling the part from the second temperature to the first temperature over a third time period.

3. The method of claim 2, wherein the annealing gas has a gas composition selected from the group consisting of an oxygen-containing mixture, air, an inert gas, forming gas, a reducing gas composition, and an oxidizing gas composition.

4. The method of claim 2, wherein the annealing gas is one of an oxygen-containing mixture, air, nitrogen, argon, and mixtures thereof, and is provided in one of a static or flow condition.

5. The method of any of claims 2 to 4, wherein the second temperature is between about 200 degrees Celsius and about 1000 degrees Celsius.

6. The method of any of claims 2 to 5, wherein during at least one of (d2) or (d4), a temperature gradient in a surface region of the part is maintained to be less than about 1 Kelvin per centimeter throughout the first or third time period.

7. The method of any of claims 2 to 6, wherein during at least one of (d2) or (d4), an internal thermal gradient is maintained within the part to be less than about 10 Joules per kilogram per Kelvin throughout the first or third time period.

8. The method of any of claims 1 to 7, wherein the part is a component part of a plasma reactor (200; 602).

9. The method of claim 8, wherein the component part is one of a lid (208; 670), a ring (300, 400; 806), an ion shield plate (272), an ion shield leg (276), a nozzle (216; 500), a gas distribution plate (664; 700) or a chamber liner (610;810).

10. The method of any of claims 2 to 9, wherein at least one of the sintering and annealing is performed in an oxygen-containing atmosphere, and (d2) and (d4) are performed at respective predetermined heating and cooling rates, the predetermined heating and cooling rates being selected based on at least the sintering atmosphere.

11. The method of claim 10, wherein the sintering atmosphere comprises an oxygen concentration of at least 2 percent by volume.

12. The method of claim 11, wherein during at least one of (d2) or (d4), a temperature gradient in a surface region of the part is maintained to be less than about 0.3 Kelvin per centimeter throughout the first or third time period.

13. The method of claim 10, wherein the sintering is performed in one of an inert or non-oxidative atmosphere, and the annealing gas has an oxygen concentration of at least 10% percent.

14. A part for use in a plasma reactor (200; 602), the part comprising at least about 99.5 percent yttria.

15. The part of claim. 14, wherein the part is one of a lid (208; 670), a ring (300, 400; 806), an ion shield plate (272), an ion shield leg (276), a nozzle (216; 500), a gas distribution plate (664; 700) or a chamber liner (610;810).

16. A plasma process chamber, comprising:
a chamber body;
a part made of at least about 99.5 percent yttria disposed in the chamber body;
a support pedestal disposed in the chamber body and adapted to receive a substrate thereon; and
a power source for forming a plasma within the chamber.
